# EUROPÄISCHE PATENTANMELDUNG

(11) **EP 1 780 159 A1**
(43) Veröffentlichungstag der Anmeldung: **02.05.2007**
(21) Anmeldenummer: 06122679.1
(22) Anmeldetag: 20.10.2006
(51) Int. Cl.: B66B 1/46

(54) **Bedienfeld für einen Aufzug und Aufzug mit einem solchen Bedienfeld**

(30) Priorität: 26.10.2005 EP 05110006
(71) Anmelder: INVENTIO AG, 6052 Hergiswil (CH)
(72) Erfinder: Liebetrau, Christoph, 5737 Menziken (CH)
(74) Vertreter: Gaussmann, Andreas

(57) **Zusammenfassung**

Bedienfeld (10) für einen Aufzug, wobei das Bedienfeld (10) mindestens ein drucksensitives Aktionsfeld (16) aufweist, um durch Drücken eine Aktion auszulösen. Das Bedienfeld (10) weist einen Schichtaufbau mit einer Deckplatte (11), einer Grundplatte (12) und einem Piezoelement (13) auf. In der Deckplatte (11) ist ein Markierung (17) vorgesehen, um das Aktionsfeld (16) zu definieren. Das Piezoelement (13) sitzt so im Bereich der Markierung (17) zwischen der Deckplatte (11) und der Grundplatte (12), dass durch das Drücken im Bereich des Aktionsfeldes (16) eine Kraft auf das Piezoelement (13) ausgeübt werden kann und das Piezoelement (13) ein elektrisches Ausgangssignal an eine elektronische Schaltung abgibt. Die elektronische Schaltung stellt ein elektrisches Rückmeldungssignal bereit, um eine an dem Bedienfeld (10) als Rückmeldung erkennbare Änderung zu bewirken.

## Beschreibung

Die Erfindung betrifft Bedienfelder für Aufzüge, nach dem Oberbegriff des Anspruchs 1 und entsprechend ausgestattete Aufzüge nach dem Oberbegriff des Anspruchs 12.

Speziell in Aufzugsanlagen werden Bedienfelder, auch Tableaus genannt, eingesetzt. Diese Bedienfelder müssen sehr vielen, zum Teil gegenläufigen Anforderungen entsprechen. Einerseits sollen sie funktionssicher sein, andererseits wird erwartet, dass sie kostengünstig sind. Vermehrt spielt heute auch die Ästhetik eine wichtige Rolle. Die Bedienfelder müssen also optisch ansprechend sein und sie sollen an das Design des Aufzugs anpassbar sein. Besonders wichtig ist, dass die Bedienfelder flach sind.

Idealerweise ist das Bedienfeld so ausgeführt, dass es im Wesentlichen unabhängig ist von der Unterkonstruktion einer Aufzugskabine oder Schachtwand.

Weiterhin müssen solche Bedienfelder hygienisch und gut zu reinigen sein. Auch die Vandalensicherheit spielt im öffentlich zugänglichen Bereichen vermehrt eine Bedeutung. Weiterhin sollten Bedienfelder behindertengerecht sein und die gesetzlichen Normen erfüllen.

Aus diesen Ausführungen wird klar, dass es nur schwer möglich ist all diesen Anforderungen gerecht zu werden.

Allgemein bekannt sind Bedienfelder mit Druckschaltern, Druckknöpfen mit Schaltmatten, mit kapazitiven Sensoren, mit Infrarotsensoren, oder mit Piezosensoren, um nur einige Beispiele zu nennen.

Es gibt Druckknopftableaus, Folieneingabefelder, Glastableaus und zahlreiche andere Varianten von Bedienfeldern. Diese Bedienfelder erfüllen jedoch jeweils nur einige der genannten Anforderungen.

Aufgabe der Erfindung ist es daher ein Bedienfeld speziell zur Verwendung in einem Aufzug zu entwickeln, das den eingangs genannten Anforderungen gerecht wird.

Diese Aufgabe wird für ein Bedienfeld erfindungsgemäss gelöst durch die Merkmale des Anspruchs 1, der ein Bedienfeld für einen Aufzug beansprucht, wobei das Bedienfeld mindestens ein drucksensitives Aktionsfeld aufweist, um durch Drücken eine Aktion auszulösen, dadurch gekennzeichnet, dass das Bedienfeld einen Schichtaufbau mit einer Deckplatte, einer Grundplatte und einem Piezoelement umfasst, wobei in der Deckplatte eine Markierung vorgesehen ist, um das Aktionsfeld zu definieren, wobei das Piezoelement so im Bereich der Markierung zwischen der Deckplatte und der Grundplatte angeordnet ist, dass durch das Drücken im Bereich des Aktionsfeldes eine Kraft auf das Piezoelement ausgeübt werden kann und das Piezoelement ein elektrisches Ausgangssignal an eine elektronische Schaltung abgibt, und wobei die elektronische Schaltung ein elektrisches Rückmeldungssignal bereit stellt, um eine an dem Bedienfeld als Rückmeldung erkennbare Änderung zu bewirken.

Ein solches Bedienfeld weist die Vorteile auf, dass es durch den flachen und geschlossenen Schichtaufbau kostengünstig, funktionssicher und optisch ansprechend ist.

Die Aufgabe wird für einen Aufzug erfindungsgemäss gelöst durch die Merkmale des Anspruchs 12, der einen Aufzug mit einem erfindungsgemäßen Bedienfeld beansprucht, wobei das Bedienfeld vorzugsweise in oder an einer Aufzugskabine des Aufzugs angeordnet ist.

Ein solcher Aufzug weist die Vorteile auf, dass er durch den flachen und geschlossenen Schichtaufbau des Bedienfelds vandalensicher ist und ein anpassbares Design aufweist.

Bevorzugte Weiterbildungen der Erfindung sind durch die vom Anspruch 1 abhängigen Ansprüche 2 bis 11, und durch den vom Anspruch 12 abhängigen Anspruch 13 definiert.

Das Bedienfeld nach Anspruch 2 weist eine elektronische Schaltung auf, die das Piezoelement als Rückmeldung mit dem Rückmeldungssignal beaufschlagt, um eine Änderung des Piezoelements zu bewirken, die im Aktionsfeld fühlbar ist. Diese Ausführungsform weist den Vorteil auf, dass das Bedienfeld behindertengerecht ist, denn auch blinde Passagiere können durch die Rückmeldung eine Bestätigung wahrnehmen, dass ein Aufzugsruf registriert worden ist.

Im Bedienfeld nach Anspruch 3 ist ein Druckelement im Bereich des Aktionsfeldes angeordnet, das die Piezoelemente und die unterliegenden elektronischen Schaltungen schützt und eine angenehme und nicht gefährliche taktile Empfindung für die Finger der Passagiere anbietet.

Im Bedienfeld nach Anspruch 4 ist das Druckelement ein im Wesentlichen zylinderförmiges Druckelement, das in der Markierung sitzt und mit einer Rückseite direkt oder indirekt auf das Piezoelement einwirkt, wenn das Druckelement gedrückt wird, so dass die Übertragung der Fingerkraft direkt und fehlersicher ist.

Im Bedienfeld nach Anspruch 5 umfasst der Schichtaufbau eine Folie, vorzugsweise eine Klebefolie, um das Piezoelement zu fixieren. Ein solches Bedienfeld weist die Vorteile auf, dass es sehr dünn sein kann und dass die Befestigung der Piezoelemente sehr einfach, kostengünstig und nicht aufwendig ist.

Im Bedienfeld nach Anspruch 6 umfasst der Schichtaufbau eine Folie, vorzugsweise eine PVB-Folie, oder eine Giessharzschicht, welche übliche praktische kostengünstige Werkstoffe für eine solche Anwendung sind.

Im Bedienfeld nach Anspruch 7 umfasst der Schichtaufbau eine Folie mit mindestens einer integrierten Leuchtdiode und gibt die Leuchtdiode Licht durch die Deckplatte hindurch ab, wenn sie mit dem Rückmeldungssignal beaufschlagt wird. Ein solches Bedienfeld weist die Vorteile auf, dass auch ein visuelles Rückmeldungssignal generiert wird, welches auch durch unaufmerksame Passagiere mit unempfindlichen Fingern empfunden werden kann.

Im Bedienfeld nach Anspruch 8 umfasst die Folie Leiterbahnen, vorzugsweise transparente Leiterbahnen, um die Leuchtdiode mit der Schaltung verbinden zu können. Der Aufbau ist dadurch sehr kompakt und ästhetisch ansprechend.

Im Bedienfeld nach Anspruch 9 besteht die Deckschicht aus Glas, welches durchsichtig ist.

Im Bedienfeld nach Anspruch 10 ist das Piezoelement auf eine Trägerschicht aufgedampft oder aufgeklebt. Durch dieses Herstellungsverfahren können sehr dünne Piezoelemente produziert werden.

Im Bedienfeld nach Anspruch 11 sind mehrere Aktionsfelder vorgesehen und jedem Aktionsfeld ist ein Piezoelement zugeordnet und mit der Schaltung verbindbar, so dass Anrufe zu verschiedenen Stockwerken verschiedenen Piezoelementen entsprechen.

Im Aufzug nach Anspruch 13 ist eine elektrische Schaltung vorhanden, um das elektrische Ausgangssignal zum empfangen und zu verarbeiten und um das Rückmeldungssignal bereit zu stellen. Die Aufzugsanlage ist damit fähig, einen Aufzugsruf zu einem bestimmten Stockwerk in Abhängigkeit des gedrückten Piezoelementes einzuteilen.

Die Erfindung wird im Folgenden an Hand von Beispielen und mit Bezug auf die Zeichnung ausführlich beschrieben. Es zeigen:
- Fig. 1: eine schematische Schnittansicht eines ersten Bedienfelds gemäss Erfindung, wobei die einzelnen Elemente vor dem Zusammenfügen gezeigt sind;
- Fig. 2A: eine schematische Schnittansicht eines zweiten Bedienfelds gemäss Erfindung, wobei die einzelnen Elemente vor dem Zusammenfügen gezeigt sind;
- Fig. 2B: eine schematische Draufsicht des zweiten Bedienfelds gemäss Erfindung;
- Fig. 3: eine schematische Schnittansicht eines dritten Bedienfelds gemäss Erfindung, wobei die einzelnen Elemente vor dem Zusammenfügen gezeigt sind;
- Fig. 4: eine schematische Schnittansicht eines vierten Bedienfelds gemäss Erfindung, wobei die einzelnen Elemente vor dem Zusammenfügen gezeigt sind;
- Fig. 5A: eine schematische Schnittansicht eines oberen Teils eines fünften Bedienfelds gemäss Erfindung;
- Fig. 5B: eine schematische Schnittansicht eines oberen Teils eines sechsten Bedienfelds gemäss Erfindung;
- Fig. 6A: eine schematische Schnittansicht eines siebten Bedienfelds gemäss Erfindung, wobei die einzelnen Elemente vor dem Zusammenfügen gezeigt sind;
- Fig. 6B: eine schematische Draufsicht des siebten Bedienfelds gemäss Erfindung. Gleiche und ähnliche bzw. gleich wirkende Bauteile sind in allen Figuren mit den gleichen Bezugszeichen versehen.

Gemäss Erfindung kommt ein Piezoelement 13 zum Einsatz, das als Drucksensor dient, der eine mechanische Betätigung in ein elektrisches Signal umwandelt. In den Figuren sind verschiedene Ausführungsformen der Erfindung gezeigt. Gemäss Erfindung wird ein kleines und dünnes Piezoelement 13 im Bereich eines sogenannten Aktionsfelds 16 angeordnet, wobei es durch einen Benutzer der Aufzugsanlage durch das Ausüben einer Druckkraft betätigt werden kann. Vorzugsweise wird das Piezoelement 13 coaxial unterhalb des Aktionsfeldes 16 angeordnet.

Besonders geeignet sind Piezoelemente 13, da sie einerseits als Druckelement durch eine Kraft, die longitudinal gerichtet ist ein elektrisches Signal zu erzeugen in der Lage sind. Andererseits kann ein Piezoelement 13, wenn es mit einem entsprechenden Rückmeldungssignal beaufschlagt wird eine Kraft oder Bewegung in umgekehrter longitudinaler Richtung erzeugen. Dadurch kann, anders als bei anderen Aktuatoren, das Verhalten eines konventionellen Druckknopfes nachgebildet werden. Von dieser "mechanischen Rückkopplung" machen einige der im Folgenden beschriebenen Ausführungsformen Gebrauch.

Eine Rückkopplung ist besonders wichtig für Benutzer eines Aufzugs, die schlecht sehen können oder blind sind. Aber auch für ältere Benutzer oder Menschen mit Behinderungen kann eine klar und deutliche Rückmeldung sehr wichtig sein.

Das Bedienfeld gemäss Erfindung kann taktile (mechanische Rückkopplung) und/oder optische und/oder akustische Rückmeldungen an den Benutzer liefern.

Um taktile Rückmeldungen (mechanische Rückkopplung) zu liefern kann das Piezoelement 13, wie bereits angedeutet, als mechanischer Aktuator dienen, der ausgelöst durch ein Rückmeldungssignal eine Reaktion (zum Beispiel eine Vibration oder eine Deformation) auslöst.

Das Piezoelement 13 kann alternativ oder ergänzend auch als Piezo-Lautsprecher dienen, der durch ein in der passenden Frequenz angelegtes Rückmeldungssignal Schallwellen erzeugt, die hörbar sind.

Das Piezoelement 13 kann alternativ oder ergänzend auch mit einer optischen Rückkopplung ausgestattet sein, wie später beschrieben wird.

Ausserdem muss ein Bedienfeld 10 mit mehreren Schalter oder Knöpfen in der Lage sein die bewusste Betätigung eines der Schalter oder Knöpfe von einem unbewussten Berühren zu unterscheiden. Auch hier bietet ein Piezoelement 13 wesentliche Vorteile gegenüber so manchen herkömmlichen berührungsempfindlichen Sensortasten, da nur eine ausreichend in longitudinaler Richtung wirkende Kraft ein elektrisches Signal mit hoher Spannung auslöst.

Ein weiterer wesentlicher Punkt der Erfindung ist die Integration der notwendigen Elemente in ein möglichst dünnes und flexibel einsetzbares Bedienfeld 10.

Daher sind monolithische (gesinterte) Piezoelemente 13 (LVPZT) besonders geeignet, die in einem ähnlichen Prozess wie Keramikkondensatoren aus mehreren Keramiklagen hergestellt werden. Diese Art von Piezoelementen 13 eignen sich besonders gut zur Integration in einen dünnen Schichtaufbau gemäss Erfindung. Solche monolithische Piezoelemente 13 werden auch als Niedervolt-Piezoaktuatoren bezeichnet. Die Keramiklagen haben typischerweise eine Dicke von 20 - 100µm. Solche Niedervolt-Piezoelemente 13 haben gegenüber anderen Piezoelementen den Vorteil, dass Spannungen von weniger als 100V ausreichen, um eine mechanische Deformation als mechanische Rückmeldung zu erzeugen.

Statt den monolithischen Piezoelementen 13 können auch piezoelektrische Polymerfilme (PVDF Polymer oder Co-Polymer) als Piezoelemente 13 eingesetzt werden. Die Dicke solcher piezoelektrischen Polymerfilme liegt unter 1000µm und vorzugsweise zwischen 10 und 200µm. Piezoelektrische Polymerfilme reagieren sehr sensibel auf mechanischen Druck und sind daher besonders gut geeignet um in dem erfindungsgemässen Bedienfeld 10 eingesetzt zu werden. Die Umwandlung eines Rückmeldungssignals in eine Deformation jedoch ist weniger stark ausgeprägt als bei anderen Piezos.

Es ist ein weiterer Vorteil von Piezoelementen 13 gegenüber vielen anderen Schaltern und Knöpfen, dass sie eine extrem hohe Lebensdauer haben.

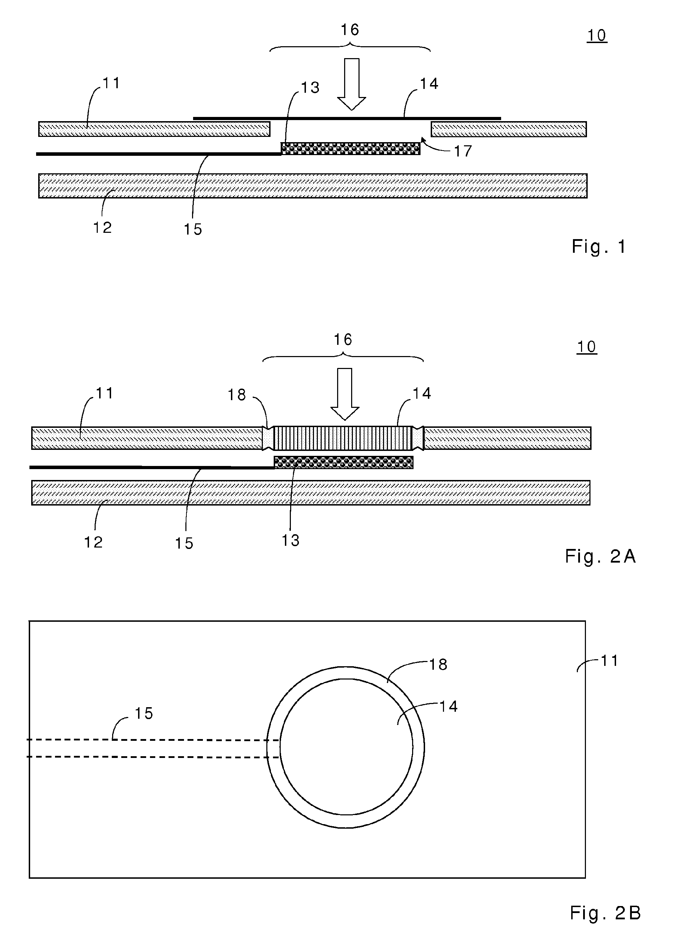

Unter Bezugnahme auf Fig. 1 werden nun weitere Einzelheiten einer ersten Ausführungsform der Erfindung beschrieben. Gezeigt ist ein Bedienfeld 10, das speziell zum Einbau in einen Aufzug ausgelegt ist. Das Bedienfeld 10 umfasst mindestens ein drucksensitives Aktionsfeld 16, um durch Drücken eine Aktion auszulösen zu können. In den Figuren ist das Drücken oder Betätigen jeweils durch einen Blockpfeil veranschaulicht.

Das Bedienfeld 10 weist gemäss Erfindung einen Schichtaufbau mindestens mit einer Deckplatte 11, einer Grundplatte 12 und einem Piezoelement 13 auf. In Fig. 1 sind diese Elemente vor dem Zusammenfügen gezeigt. Die Deckplatte 11 ist mit einer Markierung 17 in Form einer Öffnung versehen, um das Aktionsfeld 16 zu definieren. Das Piezoelement 13 ist so im Bereich der Markierung 17 zwischen der Deckplatte 11 und der Grundplatte 12 angeordnet, dass durch das Drücken im Bereich des Aktionsfeldes 16 eine Kraft auf das Piezoelement 13 ausgeübt wird. Das Piezoelement 13 wandelt diese Druckkraft in ein elektrisches Ausgangssignal um und gibt dieses an eine elektronische Schaltung ab. Diese Schaltung ist nicht in den Figuren gezeigt, da es sich nicht um ein erfindungswesentliches Element handelt und es zahlreiche Möglichkeiten gibt eine solche Schaltung zu realisieren.

Die elektronische Schaltung ist gemäss Erfindung so ausgelegt, dass sie einerseits das Ausgangssignal verarbeiten kann, um eine Aktion (zum Beispiel den Ruf einer Aufzugskabine) auszulösen und um andererseits ein elektrisches Rückmeldungssignal bereit zu stellen, um eine am Bedienfeld 10 als Rückmeldung erkennbare Änderung zu bewirken. Eine solche Rückmeldung ist, wie weiter oben beschrieben, ein wichtiges Element.

In Fig. 1 ist weiterhin zu erkennen, dass die Markierung 17 durch eine Folie oder Schutzkappe, die hier als Druckelement 14 bezeichnet wird, abgedeckt oder besetzt ist. Folie und Schutzkappe sind beispielsweise mit Zahlen, Buchstaben oder Zeichnen versehen, um Stockwerke zu kennzeichnen. Auch können Braillezeichen auf der Folie bzw. Schutzkappe angebracht sein, um blinden Passagieren zu helfen, die Stockwerke zu erkennen. Das Piezoelement 13 ist über Leitungen 15 mit der Schaltung verbunden. Diese Leitungen werden vorzugsweise zwischen den Schichten des Schichtaufbaus angeordnet. Es kann sich um Kabel oder Drähte handeln, oder es werden Leitungen eingesetzt, die auf oder in einer der Schichten integriert sind (zum Beispiel durch Aufdampfen). Die Deckplatte 11 kann auch den Piezoelement 13 abdecken und das Druckelement 14 besteht in diesem Fall aus dem Teil der Deckplatte 11, der oberhalb des Piezoelementes 13 liegt. Wenn dieser Teil der Deckplatte 11 gedrückt wird, werden Aufzugsrufe entsprechend eingegeben.

Im Folgenden werden einige Angaben zu den verwendeten Materialien gemacht, die besonders bevorzugt sind. Die Grundplatte 12 und die Deckplatte 11 können aus Glas, Kunststoff oder Metall oder einem anderen Material gefertigt sein. Besonders bevorzugt ist Glas. Als Piezoelement 13 sind keramische Mehrschicht-Piezoelement oder Piezoelemente aus piezoelektrischen Polymerfilmen besonders geeignet. Als Leitungen 15 sind durchsichtige Leiterbahnen besonders bevorzugt falls das Bedienfeld 10 durchsichtig (z.B. wenn die Deckplatte 11 aus Glas ist) ausgeführt sein sollte. Vorzugsweise wird das Piezoelement 13 auf die Grundplatte gebondet oder geklebt. Besonders bevorzugt sind Ausführungsformen bei denen eine Folie zu Einsatz kommt, die mehrere Piezoelement 13 umfasst. Als Druckelement 14 kann eine dünne Folie eingesetzt werden, die reissfest und flexibel sein sollte. Die Druckelemente können durch Bonden, Kleben oder Formschluss befestigt werden. Mehrere Druckelemente können als Verbund befestigt werden.

In den Figuren 2A und 2B ist eine zweite Ausführungsform gezeigt. Das gezeigte Bedienfeld 10 weist analog zu Fig. 1 einen Schichtaufbau mindestens mit einer Deckplatte 11, einer Grundplatte 12 und einem Piezoelement 13 auf. Diese Elemente sind vor dem Zusammenfügen gezeigt. Die Deckplatte 11 ist mit einer Markierung 17 versehen, um das Aktionsfeld 16 zu definieren. Das Piezoelement 13 ist so im Bereich der Markierung 17 zwischen der Deckplatte 11 und der Grundplatte 12 angeordnet, dass durch das Drücken im Bereich des Aktionsfeldes 16 eine Kraft auf das Piezoelement 13 ausgeübt wird. Das Piezoelement 13 wandelt diese Druckkraft in ein elektrisches Ausgangssignal um und gibt dieses an eine elektronische Schaltung ab.

In dieser Ausführungsform kommt ein Druckknopf als Druckelement 14 zum Einsatz. Dieser Druckknopf kann zum Beispiel ein aus Glas gefertigtes zylinderförmiges Element sein. Zwischen dem Druckelement und der Deckplatte wird die Fuge durch eine Art Fugendichtung 18 gefüllt. Vorzugsweise wird ein silikonartiges, flexibles Material als Fugendichtung 18 verwendet. Wichtig ist, das dieses Material einerseits das Druckelement so festhält, dass eine Verlagerung in longitudinaler Richtung möglich ist und dass andererseits die Fugendichtung 18 verhindert, dass Staub, Schmutz oder Feuchtigkeit in die Schichten des Bedienfelds 10 eindringt.

In Fig. 2B ist zu erkennen, dass das Druckelement 14 einen kreisförmigen Querschnitt hat und dass die Fugendichtung 18 das Druckelement 14 umschliesst. Weiterhin ist in Fig. 2B der Verlauf zweier Leitungen 15 angedeutet, die zu einer nicht gezeigten Schaltung führen.

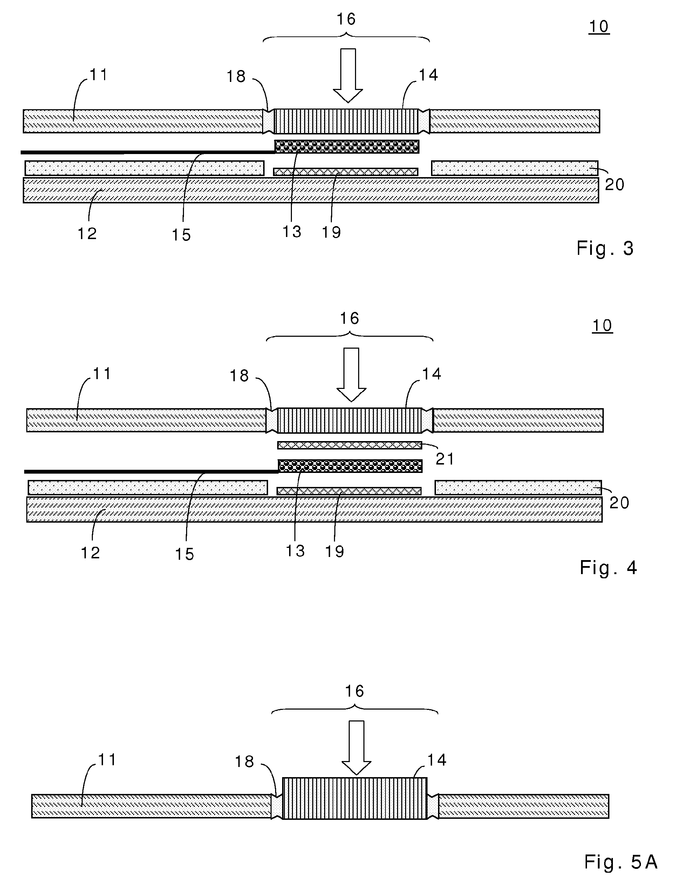

In Fig. 3 ist eine dritte Ausführungsform gezeigt. Das gezeigte Bedienfeld 10 weist analog zu Fig. 1 einen Schichtaufbau mindestens mit einer Deckplatte 11, einer Grundplatte 12 und einem Piezoelement 13 auf. Ausserdem sitzt unterhalb des Piezoelelements 13 eine Klebefolie 19. Auf der Grundplatte ist eine Folie 20 vorgesehen. Diese Elemente sind vor dem Zusammenfügen gezeigt. Die Deckplatte 11 ist mit einer Markierung 17 versehen, um das Aktionsfeld 16 zu definieren. Das Piezoelement 13 ist so im Bereich der Markierung 17 zwischen der Deckplatte 11 und der Grundplatte 12 angeordnet, dass durch das Drücken im Bereich des Aktionsfeldes 16 eine Kraft auf das Piezoelement 13 ausgeübt wird. Das Piezoelement 13 wandelt diese Druckkraft in ein elektrisches Ausgangssignal um und gibt dieses an eine elektronische Schaltung ab.

Wie bei der zweiten Ausführungsform kommt auch in dieser Ausführungsform ein Druckknopf als Druckelement 14 zum Einsatz. Dieser Druckknopf kann zum Beispiel ein aus Glas gefertigtes zylinderförmiges Element sein. Zwischen dem Druckelement und der Deckplatte wird die Fuge durch eine Art Fugendichtung 18 gefüllt.
Die untere Klebefolie 19 kann verwendet werden, um das Piezoelement 13 zu fixieren und/oder um es gegenüber der Grundplatte 12 zu isolieren.

Bei der Folie 20 kann es sich zum Beispiel um eine PolyvinylButyral (PVB) Folie handeln, wie sie heute bei Verbundsicherheitsglas verwendet wird. Damit bekommt der Schichtaufbau deutlich mehr Stabilität und er zerfällt bei Beschädigung nicht in seine Einzelteile. Die Folie 20 kann aber auch an einer anderen Position des Schichtaufbaus angeordnet sein.

In Fig. 4 ist eine vierte Ausführungsform gezeigt. Das gezeigte Bedienfeld 10 weist analog zu Fig. 1 einen Schichtaufbau mindestens mit einer Deckplatte 11, einer Grundplatte 12 und einem Piezoelement 13 auf. Ausserdem sitzen unterhalb und oberhalb des Piezoelements 13 je eine Klebefolie 19 und 21. Auf der Grundplatte ist eine Folie 20 vorgesehen. Diese Elemente sind vor dem Zusammenfügen gezeigt. Die Deckplatte 11 ist mit einer Markierung 17 versehen, um das Aktionsfeld 16 zu definieren. Das Piezoelement 13 ist so im Bereich der Markierung 17 zwischen der Deckplatte 11 und der Grundplatte 12 angeordnet, dass durch das Drücken im Bereich des Aktionsfeldes 16 eine Kraft auf das Piezoelement 13 ausgeübt wird. Das Piezoelement 13 wandelt diese Druckkraft in ein elektrisches Ausgangssignal um und gibt dieses an eine elektronische Schaltung ab.

Wie bei der zweiten oder dritten Ausführungsform kommt auch in dieser Ausführungsform ein Druckknopf als Druckelement 14 zum Einsatz. Dieser Druckknopf kann zum Beispiel ein aus Glas gefertigtes zylinderförmiges Element sein. Zwischen dem Druckelement und der Deckplatte wird die Fuge durch eine Art Fugendichtung 18 gefüllt.

Die obere Klebefolie 21 kann zum Beispiel strukturiert oder bedruckt sein, um ein Aktionsfeld 16 zu bezeichnen oder zu beschriften. Auf dieser Folie 21 kann zum Beispiel eine Zahl oder ein Buchstabe gezeigt sein. Diese Zahl oder dieser Buchstabe ist dann von aussen her durch das Druckelement 14 hindurch für den Bediener sichtbar. Die untere Klebefolie 19 kann wiederum verwendet werden, um das Piezoelement 13 zu fixieren und/oder um es gegenüber der Grundplatte 12 zu isolieren.

Bei der Folie 20 kann es sich zum Beispiel um eine PolyvinylButyral (PVB) Folie handeln, wie im Zusammenhang mit Fig. 3 beschrieben.

In Fig. 5A ist ein oberer Bereich einer weiteren Ausführungsform gezeigt. Die gezeigte Ausführungsform unterscheidet sich dadurch von der zweiten, dritten und vierten Ausführungsform, dass das Druckelement 14 erhaben ist. Dadurch steht ein oberer Bereich des Druckelements 14 aus der Deckplatte 11 hervor und ist leichter zu ertasten. Die restlichen Elemente des Bedienfeldes können aufgebaut sein wie in den Figuren 1 bis 4 gezeigt.

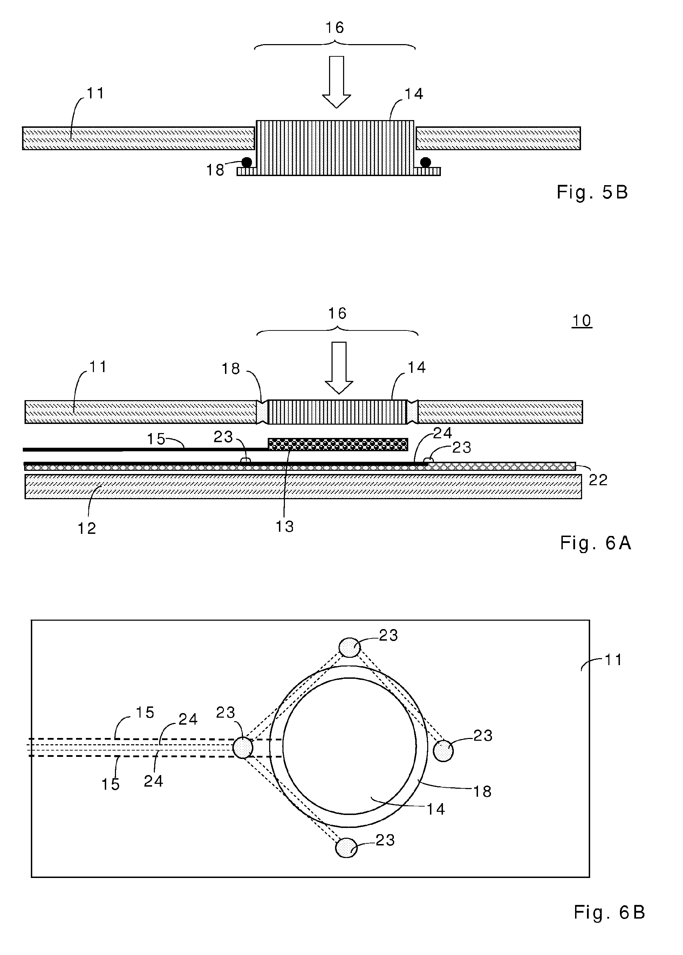

In Fig. 5B ist ein oberer Bereich einer weiteren Ausführungsform gezeigt. Die gezeigte Ausführungsform unterscheidet sich dadurch von der zweiten, dritten und vierten Ausführungsform, dass das Druckelement 14 erhaben ist. Dadurch steht ein oberer Bereich des Druckelements 14 aus der Deckplatte 11 hervor und ist leichter zu ertasten. Ausserdem hat das Druckelement einen umlaufenden Kragen, der einen Durchmesser hat, der grösser ist als der Durchmesser der Markierung 17. Steckt man das Druckelement 14 von hinten durch die Deckplatte 11, so kann es nicht nach vorn herausfallen oder mit Gewalt entnommen werden. Der umlaufende Kragen kann auch noch eine weitere Funktion haben, wie in Fig. 5B angedeutet. Er kann einen Dichtungs-/Federring 18 tragen. Die restlichen Elemente des Bedienfeldes können aufgebaut sein wie in den Figuren 1 bis 4 gezeigt.

In den Figuren 6A und 6B ist eine weitere Ausführungsform gezeigt. Das gezeigte Bedienfeld 10 weist analog zu Fig. 1 einen Schichtaufbau mindestens mit einer Deckplatte 11, einer Grundplatte 12 und einem Piezoelement 13 auf. Weiterhin ist eine Folie 22 vorgesehen, die mindesten eine integrierte oder aufgeklebte LED 23 aufweist. Diese Elemente sind vor dem Zusammenfügen gezeigt. Die Deckplatte 11 ist mit einer Markierung 17 versehen, um das Aktionsfeld 16 zu definieren. Das Piezoelement 13 ist so im Bereich der Markierung 17 zwischen der Deckplatte 11 und der Grundplatte 12 angeordnet, dass durch das Drücken im Bereich des Aktionsfeldes 16 eine Kraft auf das Piezoelement 13 ausgeübt wird. Das Piezoelement 13 wandelt diese Druckkraft in ein elektrisches Ausgangssignal um und gibt dieses an eine elektronische Schaltung ab. Neben dem Piezoelement 13 sind LEDs 23 angeordnet. Die Anordnung wurde so gewählt, dass die LEDs 23 von aussen her entweder durch das Druckelement 14 hindurch oder durch die Deckplatte 11 hindurch sichtbar sind. Die LEDs 23 werden über Leitungen 24 mit einer Spannung beaufschlagt.

In oder auf der Folie 22 werden LEDs 23 eingesetzt, die ein niedrige Wärmeentwicklung, eine hohe Lebenserwartung und eine sehr flache Bauweise aufweisen. Idealerweise wird die Folie 22 mit den LEDs 23 zwischen zwei PVB-Folien eingesetzt.

Es können LEDs 23 mit verschiedenen Farben eingesetzt werden.

In Fig. 6B kann man erkennen, dass insgesamt vier LEDs 23 im Bereich des Umfangs des Druckelements 14 angeordnet sind und dass die Leitungen 24 zusammen mit dem Leitungen 15, die mit dem Piezoelement 13 verbunden sind, zu einer nicht gezeigten Schaltung führen. Die LEDs 23 können verwendet werden, um dem Benutzer optisch zu signalisieren, dass er ein bestimmtes Aktionsfeld 16 erfolgreich betätigt hat. Zu diesem Zweck sendet die Schaltung ein Rückmeldungssignal an die LEDs 23.

In dieser Ausführungsform kommt ein Druckknopf als Druckelement 14 zum Einsatz. Dieser Druckknopf kann zum Beispiel ein aus Glas gefertigtes zylinderförmiges Element sein. Zwischen dem Druckelement und der Deckplatte wird die Fuge durch eine Art Fugendichtung 18 gefüllt.

In einer weiteren Ausführungsform wird eine Beschriftung oder Struktur in das Druckelement 14 eingefräst oder geätzt. Auf dem Druckelement kann zum Beispiel eine Zahl oder ein Buchstabe gezeigt sein. Diese Zahl oder dieser Buchstabe ist dann von aussen her für den Bediener sicht- und/oder spürbar.

Die eingefräste oder geätzte Struktur oder Beschriftung kann mit einer speziellen Farbe gefüllt sein, um durch das Licht der LEDs 23 angeregt zu werden. Dadurch kann man die Struktur oder die Beschriftung quasi indirekt zum Leuchten bringen.

In einer weiteren Ausführungsform der Erfindung wird das Piezoelement 13 so beschaltet, das die elektrische Energie, die beim Drücken erzeugt wird einerseits dazu dient, um ein Signal an die Schaltung zu senden (um damit eine Aktion auszulösen) und andererseits eine oder mehrere LEDs speist, um so eine unmittelbare optische Rückmeldung zu geben. In diesem Fall wird das Piezoelement nicht nur als Spannungs- sondern auch als Ladungsquelle benutzt. Mit den erzeugten Ladungen kann eine Speicherkapazität gespeist und von dort eine oder mehrere LEDs versorgt werden. Um mit der relative hohen Spannung und den niedrigen Strömen eines Piezoelements LEDs anzusteuern, empfiehlt es sich einen Transformator einzusetzen, der im sekundären LED Kreis eine niedrigere Spannung aber einen höheren Strom hat.

Falls man wünscht, dass ein Teil des Schichtaufbaus transparent ist, so eignen sich Glas als Deckplatte 11 und transluzente Folien für die Zwischenschichten.

Besonders bewährt hat sich ein laminierter Schichtaufbau mit Glasplatten als Deck- und Grundplatte 11, 12. Eine Folie mit Piezoelementen 13 und eine Folien mit LEDs 23 kann zwischen diese Platten 11, 12 einlaminiert werden.

Vorzugsweise kommt eine elektrische Schaltung zum Einsatz, die ein Ausgangssignal eines Piezoelements verstärkt, falls notwendig, und weiter verarbeitet.

Vorzugsweise kommt eine elektrische Schaltung zum Einsatz, die so ausgelegt ist, dass durch Anlegen einer umgekehrt gepolten Spannung (Deaktivierungssignal) eines oder mehrere der Piezoelemente sich zusammenziehen. Dadurch kann ein Aktionsfeld 16 vorübergehend deaktiviert werden, da entweder keine mechanische Kopplung mehr zwischen dem entsprechenden Piezoelement 13 und dem darüber sitzenden Druckelement 14 besteht, oder da das Druckelement 14 durch die Kontraktion des Piezoelements 13 aus dem Bedienfeld 10 zurück gezogen wird. Der gleiche Effekt kann auch ereicht werden, wenn die Druckelemente 14 und Piezoelemente 13 so ausgelegt sind, dass ohne das Anlegen einer Aktivierungsspannung das Druckelement 14 nicht aus dem Bedienfeld herausragt. Erst wenn von der Schaltung eine Aktivierungsspannung angelegt wird, dehnt sich das Piezoelement 13 aus und drückt das Druckelement 14 nach vorne, so dass es in Bezug auf das Bedienfeld erhaben ist.

Das erfindungsgemässe Bedienfeld 10 bietet einen unmittelbaren Zusammenhang zwischen einer Aktion (dem Drücken eines Knopfes) und einer Reaktion (fühl-, hör und/oder sichtbar).

Das erfindungsgemässe Bedienfeld 10 ist besonders flach und kann unabhängig von der Unterkonstruktion eingesetzt werden. Das Bedienfeld 10 lässt sich optimal gestalten und kann somit den verschiedensten Ansprüchen genügen. Es lässt sich leicht und problemlos reinigen und ist besonders vandalensicher.

## Patentansprüche

1. Bedienfeld (10) für einen Aufzug, wobei das Bedienfeld (10) mindestens ein drucksensitives Aktionsfeld (16) aufweist, um durch Drücken eine Aktion auszulösen, **dadurch gekennzeichnet, dass** das Bedienfeld (10) einen Schichtaufbau mit einer Deckplatte (11), einer Grundplatte (12) und einem Piezoelement (13) umfasst, wobei
- in der Deckplatte (11) eine Markierung (17) vorgesehen ist, um das Aktionsfeld (16) zu definieren,
- das Piezoelement (13) so im Bereich der Markierung (17) zwischen der Deckplatte (11) und der Grundplatte (12) angeordnet ist, dass durch das Drücken im Bereich des Aktionsfeldes (16) eine Kraft auf das Piezoelement (13) ausgeübt werden kann und das Piezoelement (13) ein elektrisches Ausgangssignal an eine elektronische Schaltung abgibt, und
- wobei die elektronische Schaltung ein elektrisches Rückmeldungssignal bereitstellt, um eine an dem Bedienfeld (10) als Rückmeldung erkennbare Änderung zu bewirken.

2. Das Bedienfeld (10) nach Anspruch 1, wobei die elektronische Schaltung das Piezoelement (13) als Rückmeldung mit dem Rückmeldungssignal beaufschlagt, um eine Änderung des Piezoelements (13) zu bewirken, die im Aktionsfeld (16) fühlbar ist.

3. Das Bedienfeld (10) nach Anspruch 1 oder 2, wobei im Bereich des Aktionsfeldes (16) ein Druckelement (14) angeordnet ist.

4. Das Bedienfeld (10) nach Anspruch 3, wobei das Druckelement (14) ein im Wesentlichen zylinderförmiges Druckelement (14) ist, das in der Öffnung (17) sitzt und mit einer Rückseite direkt oder indirekt auf das Piezoelement (13) einwirkt wenn das Druckelement (14) gedrückt wird.

5. Das Bedienfeld (10) nach einem der vorhergehenden Ansprüche, wobei der Schichtaufbau eine Folie, vorzugsweise eine Klebefolie (19, 21) umfasst, um das Piezoelement (13) zu fixieren.

6. Das Bedienfeld (10) nach einem der vorhergehenden Ansprüche, wobei der Schichtaufbau eine Folie (20), vorzugsweise eine PVB-Folie, oder eine Giessharzschicht umfasst.

7. Das Bedienfeld (10) nach einem der vorhergehenden Ansprüche, wobei der Schichtaufbau eine Folie (22) mit mindestens einer integrierten Leuchtdiode (23) umfasst und die Leuchtdiode Licht durch die Deckplatte (11) hindurch abgibt wenn sie mit dem Rückmeldungssignal beaufschlagt wird.

8. Das Bedienfeld (10) nach Anspruch 7, wobei die Folie (22) Leiterbahnen (24), vorzugsweise transparente Leiterbahnen, umfasst, um die Leuchtdiode (23) mit der Schaltung verbinden zu können.

9. Das Bedienfeld (10) nach einem der vorhergehenden Ansprüche, wobei die Deckschicht (11) aus Glas besteht.

10. Das Bedienfeld (10) nach einem der vorhergehenden Ansprüche, wobei das Piezoelement (13) auf eine Trägerschicht (12; 19; 22) aufgedampft oder aufgeklebt ist.

11. Das Bedienfeld (10) nach einem der vorhergehenden Ansprüche, wobei mehrere Aktionsfelder (16) vorgesehen sind und jedem Aktionsfeld (16) ein Piezoelement (13) zugeordnet und mit der Schaltung verbindbar ist.

12. Aufzug mit einem Bedienfeld (10) nach einem der vorhergehenden Ansprüche, wobei das Bedienfeld vorzugsweise in oder an einer Aufzugskabine des Aufzugs angeordnet ist.

13. Der Aufzug nach Anspruch 12, wobei eine elektrische Schaltung vorhanden ist, um das elektrische Ausgangssignal zum empfangen und zu verarbeiten und um das Rückmeldungssignal bereit zu stellen.
